# EUROPÄISCHE PATENTSCHRIFT

(11) **EP 1 065 624 B1**
(45) Veröffentlichungstag und Bekanntmachung des Hinweises auf die Patenterteilung: **03.03.2004**
(21) Anmeldenummer: 00113089.7
(22) Anmeldetag: 27.06.2000
(51) Int. Cl.: G06K 19/07, G06K 19/077

(54) **Chipmodul zum Einbau in einen Chipkartenträger**
Chip module for installation in a chip card carrier
Module puce à monter dans un support de carte à puce

(30) Priorität: 28.06.1999 DE 19929610
(43) Veröffentlichungstag der Anmeldung: 03.01.2001
(73) Patentinhaber: Giesecke & Devrient GmbH, 81677 München (DE)
(72) Erfinder: Haghiri-Tehrani, Yahya, 80797 München (DE); Tarantino, Thomas, 83470 Laufen (DE); Wiech, Oliver, 81677 München (DE)
(74) Vertreter: Klunker . Schmitt-Nilson . Hirsch

(56) Entgegenhaltungen:
- DE-C- 19 733 124
- FR-A- 2 659 767

## Beschreibung

Die vorliegende Erfindung betrifft ein Chipmodul mit einem Modulträger mit mindestens einer elektrischen Kontaktfläche auf einer Seite des Modulträgers, mindestens einem elektrischen Bauteil auf der gegenüberliegenden Seite des Modulträgers und Durchbrechungen für die Kontaktierung der Kontaktfläche und des Bauteils. Weiterhin betrifft die Erfindung eine Chipkarte mit mindestens einem solchen Chipmodul, wobei die elektrische Kontaktfläche des Chipmoduls mit einem Bauelement im Chipkartenkörper verbunden sind. Außerdem bezieht sich die Erfindung auf Verfahren zur Herstellung des Chipmoduls und der Chipkarte.

Bei den meisten Lesegeräten findet ein Datenaustausch mit der Chipkarte über Kontaktflächen statt, welche sich außen auf der Chipkarte befinden. Darüber hinaus gibt es aber auch Lesegeräte, welche mit einer kontaktlosen Datenübertragung arbeiten. Hierzu weist die Chipkarte in ihrem Chipkartenkörper ein entsprechendes Bauelement zur kontaktlosen Datenübertragung auf, beispielsweise eine Antenne bzw. eine Antennenspule. Je nachdem in welchen Lesegeräten eine Chipkarte gelesen werden soll, muß diese folglich mit dem entsprechenden Interface, das heißt entweder mit Kontaktflächen oder mit einer Antenne ausgestattet sein.

Um eine Chipkarte in Verbindung mit verschiedenen Typen von Lesegeräten einsetzen zu können und so den Einsatzbereich zu erweitern, werden sogenannte Dual-Interface-Karten hergestellt, die sowohl die außenliegenden Kontaktflächen als auch ein parallel dazu geschaltetes Interfacebauelement zur kontaktlosen Übertragung aufweisen.

Die außenliegenden Kontaktflächen befinden sich in der Regel auf der Außenseite eines sogenannten Chipmoduls, welches auf der gegenüberliegenden "Innenseite" ein elektrisches Bauteil, das heißt den eigentlichen Chip, trägt. Der Chip wird mit den Kontaktflächen durch den Modulträger hindurch kontaktiert. Die Kontaktierung erfolgt üblicherweise im Bondingverfahren. Dabei werden feine Drähte von den Kontakten des Chips durch Durchbrechungen im Modulträger hindurch zu den Kontaktflächen gezogen. Bei der Herstellung einer Karte, welche nur einen Datenaustausch über die Kontaktflächen ermöglicht, wird dieses fertige Chipmodul beispielsweise in einen Chipkartenkörper aus Kunststoff mit einer entsprechenden Vertiefung eingeklebt.

Da für eine Antennenspule oder ein ähnliches Bauelement zur kontaktlosen Datenübertragung eine vergleichsweise große Fläche benötigt wird, ist eine Unterbringung im Chipmodul nur bedingt möglich. Derartige Bauelemente werden daher in dem Chipkartenkörper untergebracht. Beim Einbau des Chipmoduls muß dann eine einwandfreie Kontaktierung zwischen dem Chipmodul bzw. dem Chip und den Kontakten des Interfacebauelements gewährleistet werden. Bei der Herstellung von Dual-Interface-Karten muß entsprechend dafür gesorgt werden, daß sowohl eine Kontaktierung des Chips zu den Kontaktflächen als auch zum Interfacebauelement im Chipkartenkörper erfolgt.

Zur Kontaktierung des Chipmoduls mit dem Interfacebauelement im Chipkartenkörper verwendet man spezielle Module, die im Unterschied zu den herkömmlichen Modulen auf der Innenseite zusätzliche Leiterbahnen für die Kontaktierung des Moduls bzw. des Chips mit dem Interfacebauelement aufweisen. Diese Leiterbahnen werden mit Bonddrähten mit den Kontakten des Chips verbunden und haben je ein freises Ende, für die Kontaktierung mit dem Interfacebauelement.

Diese Art der Kontaktierung wird auch als Flip-Chip-Technologie bezeichnet (siehe "Lexikon Elektronik und Mikroelektronik", 2. Auflage, VDI-Verlag 1993, S.330). Um eine sichere elektrische Kontaktierung zu erreichen, werden sogenannte "Ball Bumps" verwendet. Dazu wird ein Draht an eines der Bauteile angebondet und beispielsweise durch Erhöhen des Bondstromes abgeschmolzen oder abgerissen. Dadurch entsteht eine elektrisch leitende Erhöhung, die sich beim Aufeinandersetzen der Bauteile in eine Kontaktstelle des gegenüberliegenden Bauteils eindrückt und die elektrische Verbindung herstellt. Ähnliche Techniken werden auch in der WO 96/24944 und der EP 0 094 716 beschrieben. Ein großer Vorteil dieser Techniken besteht darin, daß keine zusätzlichen Verbindungstechniken, wie beispielsweise Leitkleben, Löten, Schweißen oder dergleichen erforderlich sind.

Die Technologie ist jedoch, wie bereits oben erwähnt, an sich auf den Einsatz bei Flip-Chips beschränkt, bei denen das eine elektrische Bauteil direkt auf das andere Bauteil aufgesetzt wird. Es ist daher erforderlich, daß das Chipmodul bzw. der Modulträger auch auf der Seite, auf der sich der Chip befindet, Kontaktflächen aufweist, die dann beim Einbringen des Chipmoduls in den Chipkartenkörper über Ball Bumps oder dergleichen mit dem Interfacebauelement verbunden werden. Zur Herstellung solcher Chipmodule wird daher als Ausgangsmaterial ein sogenanntes doppelseitiges Modulträgerband verwendet, welches beidseitig Kontaktflächen aufweist Selbstverständlich muß auch dafür gesorgt werden, daß die Kontaktflächen auf der bauteilseitigen Oberfläche des Modulträgers mit den außenseitigen Kontaktflächen bzw. mit dem Chip verbunden werden.

DE-A-19 733 124 offenbart ein Chipkartenmodul, in dem Durchbrüche im Modulträger mit einem leitfähigen Material gefüllt sind und somit die Verbindung zwischen äußeren Kontakten und Antenne im Kartenkörper hergestellt werden kann. Es stellt sich die Aufgabe, eine kostengünstige Alternative zu diesem bekannten Stand der Technik zu schaffen.

Diese Aufgabe wird durch ein Chipmodul und eine Chipkarte mit einem entsprechenden Chipmodul gemäß den nebengeordneten Produktansprüchen gelöst. Das erfindungsgemäße Chipmodul bzw. die Chipkarte sind durch Verfahren gemäß den nebengeordneten Verfahrensansprüchen herstellbar.

Die Grundidee der Erfindung besteht darin, daß auf der das Bauteil aufweisenden Seite des Modulträgers des Chipmoduls mindestens eine Kontaktbrücke angeordnet ist, welche an ihren beiden Enden durch Durchbrechungen im Modulträger hindurch mit der außenseitigen Kontaktfläche verbunden ist. Über die Kontaktbrücke kann dann beim Einsetzen des Chipmoduls in den Chipkartenkörper ein Kontakt zwischen den Kontaktflächen auf der Außenseite des Chipmoduls und den Kontakten des Interfacebauelements hergestellt werden. Es ist bei dieser Verbindungslösung folglich kein doppelseitiges Modulträgerband erforderlich, sondern es kann ein kostengünstigeres Modulträgerband verwendet werden, wie es auch für die Herstellung von einfachen Chipkarten verwendet wird, die nur für einen Datenaustausch über Kontaktflächen vorgesehen sind. Da die Verbindungsstellen der Kontaktbrücken mit den Kontaktflächen sich innerhalb der Durchbrechungen des Modulträgers befinden, sind diese Verbindungsstellen zudem durch den Modulträger geschützt, so daß sie beim Implantieren des Chipmoduls in den Chipkartenkörper nicht belastet oder abgerissen werden.

Die Kontaktbrücken können prinzipiell aus jedem beliebigen elektrisch leitenden Material bestehen. Vorzugsweise handelt es sich jedoch um Bonddraht wobei unter Bonddraht in diesem Sinne ein Draht, beispielsweise ein feiner Golddraht, zu verstehen ist, der zum Bonden mit den herkömmlichen Verfahren und Einrichtungen geeignet ist.

Um die Funktionssicherheit zu erhöhen, werden vorteilhafterweise mindestens zwei Brücken zueinander parallel gebondet, so daß bezüglich der Kontaktierung eine Redundanz vorliegt.

Bei einem besonders bevorzugten Ausführungsbeispiel wird vor dem Herstellen der Kontaktbrücken auf die bauteilseitige Oberfläche des Modulträgers eine Kleberschicht aufgebracht, welche an den Durchbrechungen des Modulträgers entsprechende Aussparungen für die Enden der Kontaktbrükke aufweist. Die Kleberschicht ist vorzugsweise ein Kleberfilm, beispielsweise ein Thermokleber oder dergleichen, der auf den Modulträger auflaminiert wird. Die Aussparungen können beispielsweise vor dem Aufbringen auf den Modulträger durch Ausstanzen in den Kleberfilm eingebracht werden.

Ein derartiges Chipmodul weist den Vorteil auf, daß die Kontaktbrücken beim Implantieren in den Chipkartenkörper durch die Kleberschicht schonend gepolstert werden. Die Verbindungsstelle zwischen den Kontaktbrükken und den Kontakten des Interfacebauelements wird durch die Kleberschicht gegen dynamische Beanspruchung gut abgesichert. Weiterhin wird die Druckbelastung auf die Kontakte beim Implantieren durch den Kleber "eingefroren". Dies führt zu einem stabilen und niedrigen Kontaktwiderstand.

Vorteilhafterweise weist die Kleberschicht außerdem eine Aussparung für den Chip auf. Der Chip wird dann erst nach dem Aufbringen der Kleberschicht auf bekannte Weise mit einer Vergußmasse vergossen, wobei der Rand der Aussparung als Vergußrand dient und so auf einfache Weise ein sauberer Abschluß der Vergußmasse erreicht wird.

Ebenso können zum Schutz der Verbindungsstellen der Kontaktbrücken mit der Kontaktfläche diese lokal mit einer Vergußmasse vergossen werden, indem beispielsweise die Durchbrechungen des Modulträgers mit Vergußmasse aufgefüllt werden. Hierdurch wird die Stabilität der Verbindungsstellen erhöht.

Die Chipmodule werden dann wie üblich in eine entsprechend geformte Ausnehmung in einem Chipkartenkörper eingesetzt, wobei die Kontaktbrücken am Chipmodul automatisch die Kontakte des Bauelements im Chipkartenkörper beaufschlagen. Bei Verwendung der zuvor beschriebenen Kleberschicht wird diese dazu benutzt, das Chipmodul in den Chipkartenkörper einzukleben.

Die Erfindung findet ihren Einsatz vorwiegend bei Dual-Interface-Karten, wobei das Bauelement im Chipkartenkörper ein Interfacebauelement zur kontaktlosen Datenübertragung ist Sie ist selbstverständlich aber nicht auf diese Anwendung beschränkt. Bei dem Bauelement im Chipkartenkörper kann es sich auch um beliebige andere Bauelemente handeln, beispielsweise um Kontakte, die zu einem weiteren Chip bzw. Chipmodul führen.

Die Erfindung wird nachfolgend anhand von Ausführungsbeispielen unter Hinweis auf die beigefügten Zeichnungen näher erläutert. Es stellen dar:
Fig. 1 einen Schnitt durch ein Chipmodul gemäß einem ersten Ausführungsbeispiel beim Einsetzen in einen Chipkartenkörper (nur teilweise dargestellt),
Fig. 2 einen Schnitt durch ein Chipmodul gemäß einem zweiten Ausführungsbeispiel,
Fig. 3 einen Schnitt durch ein Chipmodul gemäß einem dritten Ausführungsbeispiel,
Fig. 4 eine schematische Draufsicht auf einen Ausschnitt eines Chipmodul gemäß Fig. 1 mit zwei parallelen Kontaktbrücken von der Bauteilseite aus gesehen.

Wie in den Figuren gezeigt, besteht das erfindungsgemäße Chipmodul 1 aus einem Modulträger 2, auf dem sich auf der einen Seite, der späteren Außenseite, die elektrischen Kontaktflächen 3 befinden. Auf der den Kontaktflächen 3 gegenüberliegenden Innenseite des Chipmoduls ist das elektrische Bauteil 4, das heißt der Chip 4, angeordnet.

In dem Modulträger 2 befinden sich benachbart zum Chip 4 Durchbrechungen 5. Mit Bonddrähten 6 sind die Kontakte des Chips 4 mit den Kontaktflächen 3 des Chipmoduls verbunden. Wie bei einem herkömmlichen Chipmodul ist der Chip 4 gemeinsam mit den Bonddrähten 6 in einer Vergußmasse 7 fest eingegossen, so daß der Chip 4 und die Bonddrähte 6 geschützt sind.

Neben den Durchbrechungen 5 für die Bonddrähte 6 zwischen dem Chip 4 und den Kontaktflächen 3 befinden sich im Chipmodul 1 weitere Durchbrechungen 11, die von der den Chip 4 aufweisenden Seite des Modulträgers 2 bis zu den Kontaktflächen 3 führen. Zwischen zwei Durchbrechungen 11 sind jeweils Kontaktbrücken 10 aus Bonddraht gezogen. Diese Kontaktbrükken 10 sind in den beiden Durchbrechungen 11 an ihren Enden 12,13 mit den bekannten Bondingmethoden an der jeweiligen Kontaktfläche 3 befestigt. Die Kontaktbrücken 10 bilden folglich auf der den Chip 4 aufweisenden Innenseite des Modulträgers 2 jeweils einen offen liegenden Kontakt zu der entsprechenden Kontaktfläche 3 auf der Außenseite des Modulträgers 2.

Die Modulträger 2 werden üblicherweise aus einem fertig konfektionierten Modulträgerband hergestellt. Auf dieses Modulträgerband werden die Chips 4 aufgesetzt und dann mit den Kontaktflächen 3 gebondet. Die Erzeugung der Kontaktbrücken 10 ist mit den gleichen Geräten und den gleichen Verfahren wie das Bonden zwischen dem Chip 4 und den Kontaktflächen 3 möglich. Die Herstellung eines erfindungsgemäßen Chipmoduls 1 erfordert folglich lediglich einen weiteren Verfahrensschritt, bei dem die Kontaktbrücken 10 gebondet werden. Das Herstellen der Durchbrechungen 11 für die Kontaktbrücken 10 kann in einem Arbeitsgang mit der Herstellung der Durchbrechung 5 für die Bonddrähte 6 zwischen dem Chip 4 und den Kontaktflächen 3 erfolgen. Der Mehraufwand bei der Herstellung solcher Chipmodule 1 gegenüber herkömmlichen Chipmodulen ist daher gering.

Die fertigen Chipmodule 1 werden dann in entsprechende Aussparungen 23 im Chipkartenkörper 20 eingesetzt. Die Aussparung 23 besteht hierbei aus einem ersten Abschnitt 24, welcher an die Außenmaße des Modulträgers 2 angepaßt ist, so daß der Modulträger 2 bündig mit der Oberfläche des Chipkartenkörpers 20 in die Aussparung 23 eingelegt werden kann. In der Mitte dieses ersten Aussparungsabschnitts 23 befindet sich ein weiterer Abschnitt 25 in Form einer topfartigen Vertiefung 25, in welche der mit der Vergußmasse 7 umhüllte Chip 4 hineinpaßt.

Neben dem topfartigen tieferen Abschnitt 25 befinden sich an der Grundfläche des breiteren oberen Abschnitts 24 der Aussparung 23 offene Kontakte 22 eines im Chipkartenkörpers 20 angeordneten Bauelements 21, hier einer Antennenspule 21.

Die Kontakte 22 in der Aussparung 24 bzw. die Kontaktbrücken 10 am Chipmodul 1 sind so ausgerichtet, daß beim Einsetzen des Chipmoduls 1 in die Aussparung 23 des Chipkartenkörpers 20 die Kontaktbrücken 10 die zugehörigen Kontakte 22 kontaktieren. Auf diese Weise wird zwischen den Kontaktflächen 3 und den Kontakten 22 der Antennenspule 21 ein Kontakt hergestellt. Über die Bonddrähte 6 ist damit auch die Antennenspule 21 mit dem Chip 4 verbunden.

Um eine hohe Funktionssicherheit zu gewährleisten, sind für jede Kontaktfläche 3 mindestens zwei Kontaktbrücken 10 parallel zueinander geschaltet. Wie in Figur 4 zu sehen ist, werden hierbei jeweils die beiden Enden 12,13 einer Kontaktbrücke 10 mit unterschiedlichen Bondingmethoden mit der Kontaktfläche 3 verbunden, wobei außerdem darauf geachtet wird, daß die jeweils zueinander benachbart angeordneten Enden 12,13 der parallelen Kontaktbrücken 10 ebenfalls mit den unterschiedlichen Bondingmethoden mit der Kontaktfläche 3 verbunden sind. Mit anderen Worten werden die beiden parallelen Kontaktbrücken 10 so mit der Kontaktfläche 3 verbunden, daß jeweils die über Kreuz liegenden Enden 12 mit einem Bondingverfahren, beispielsweise einem "Ball"-Verfahren, und die beiden anderen Enden 13 jeweils mit einem anderen Bondingverfahren, beispielsweise einem "Wedge"-Verfahren, befestigt werden. Durch diese redundante Anordnung der Kontaktbrücken 10 ist eine höchstmögliche Kontaktsicherheit gewährleistet.

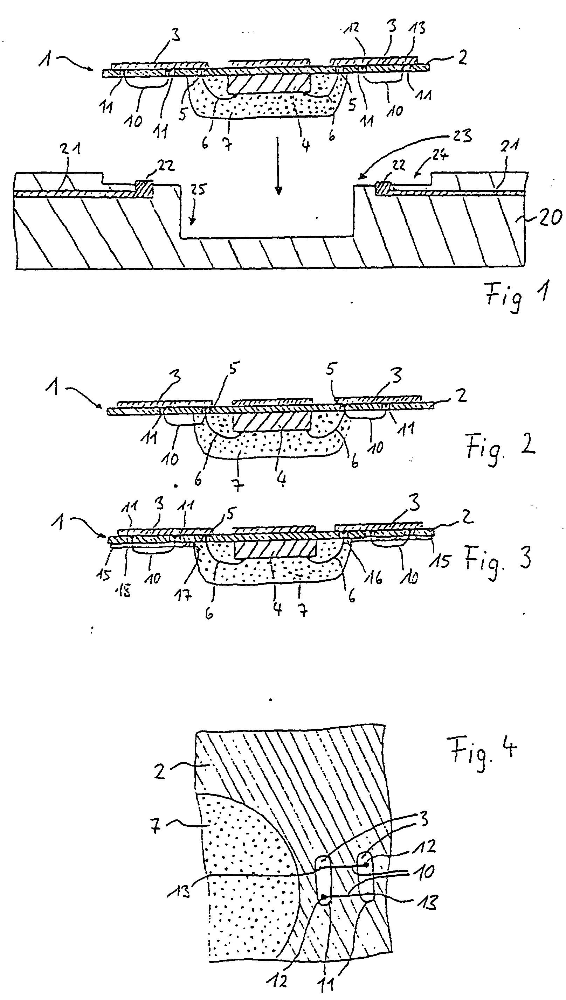

Figur 2 zeigt ein alternatives Ausführungsbeispiel des erfindungsgemäßen Chipmoduls 1. Hierbei wurde neben den Aussparungen 5 für die Bonddrähte 6 zwischen dem Chip 4 und den Kontaktflächen 3 lediglich eine weitere Durchbrechung 11 pro Kontaktbrücke 10 in den Modulträger 2 eingebracht. Die Kontaktbrücken 10 wurden dann zwischen den Durchbrechungen 5 und den weiteren äußeren Durchbrechungen 11 gezogen. Es wird somit eine Bondstelle eingespart. Beim Ziehen der Bonddrähte 6 kann von dem Bondinggerät in einem zusammenhängenden Arbeitsgang auch die jeweilige Kontaktbrücke 10 gezogen werden.

Weitere zusätzliche Vorteile bietet das Ausführungsbeispiel gemäß Figur 3. Hierbei wird vor dem Bonden der Kontaktbrücken 10 auf die Innenseite des Modulträgers 2 ein Kleberflim 15 auflaminiert. Dieser Kleberfilm 15 ist im Bereich der Durchbrechungen 11 des Modulträgers 2 sowie im Bereich des Chips 4 ausgestanzt. Beim Vergießen des Chips 4 mit der Vergußmasse 7 kann daher der Rand 17 der Aussparung 16 des Kleberfilms 15 um den Chip 4 als Vergußrand benutzt werden, so daß hier automatisch eine Begrenzung für die Vergußmasse 7 vorliegt. Mittels des Kleberfilms 15 wird dann das Chipmodul 1 in den Chipkartenkörper 20 eingeklebt. Bei dem Kleberfllm 15 kann es sich beispielsweise um einen Thermokleber handeln, der unter der entsprechenden Temperatur aushärtet.

Durch den Kleberfilm 15 werden die Kontaktbrücken 10 beim Implantieren schonend gepolstert. In der fertigen Chipkarte werden die Kontaktbrücken bzw. die Kontakte der Antennenspule 21 durch den Kleberfilm 15 gegen dynamische Beanspruchung abgesichert. Zudem wird die Druckbelastung auf die Kontakte 22 beim Implantieren durch den Kleber fixiert, wodurch ein stabiler und niedriger Kontaktwiderstand gewährleistet ist.

Bei einem nicht dargestellten Ausführungsbeispiel werden die Verbindungsstellen der Kontaktbrücken 10 mit den Kontaktflächen 3 lokal mit einem Harz umgossen, das heißt die Durchbrechungen 11 im Modulträger 2 werden mit einer Vergußmasse aufgefüllt. Hierdurch wird die Sicherheit der Kontaktierung beim Einbau des Chipmoduls 1 in den Chipkartenkörper 20 erhöht.

Es ist offensichtlich, daß die vorliegende Erfindung, abweichend von der vorliegenden Beschreibung, prinzipiell auch für Chipkarten verwendet werden kann, die ausschließlich kontaktlos arbeiten, d. h. als Interfacebauelement lediglich eine eingebettete Antenne aufweisen.

## Patentansprüche

1. Chipmodul (1) mit einem Modulträger (2) mit mindestens einer elektrischen Kontaktfläche (3) auf einer Seite des Modulträgers (2) und mindestens einem elektrischen Bauteil (4) auf der gegenüberliegenden Seite des Modulträgers (2) und mit Durchbrechungen (5) für die Kontaktierung (6) der Kontaktfläche (3) und des Bauteils (4), **dadurch gekennzeichnet, daß** auf der das Bauteil (4) aufweisenden Seite des Modulträgers (2) mindestens eine Kontaktbrücke (10) angeordnet ist, welche an ihren beiden Enden (12, 13) durch Durchbrechungen (11) im Modulträger (2) hindurch mit der Kontaktfläche (3) verbunden ist.

2. Chipmodul nach Anspruch 1, **dadurch gekennzeichnet, daß** die Kontaktbrücke (10) aus Bonddraht besteht.

3. Chipmodul nach Anspruch 1 oder 2, **dadurch gekennzeichnet, daß** eines der Enden (12, 13) der Kontaktbrücke (10) durch eine Durchbrechung (5) für die Kontaktierung (6) der Kontaktfläche (3) mit dem Bauteil (4) durchgeführt ist.

4. Chipmodul nach einem der Ansprüche 1 bis 3, **gekennzeichnet durch** mindestens zwei parallel zueinander mit der Kontaktfläche (3) verbundene Kontaktbrücken (10).

5. Chipmodul nach einem der Ansprüche 1 bis 4, **dadurch gekennzeichnet, daß** die beiden Enden (12,13) der mindestens einen Kontaktbrücke (10) mittels unterschiedlicher Bondingmethoden mit der Kontaktfläche (3) verbunden sind.

6. Chipmodul nach Anspruch 4 oder 5, **dadurch gekennzeichnet, daß** die jeweils zueinander benachbart angeordneten Enden (12,13) paralleler Kontaktbrücken (10) mittels unterschiedlicher Bondingmethoden mit der Kontaktfläche (3) verbunden sind.

7. Chipmodul nach einem der Ansprüche 1 bis 6, **dadurch gekennzeichnet, daß** der Modulträger (2) eine sich zwischen dem Modulträger (2) und der/ den Kontaktbrücke(n) (10) auf der bauteilseitigen Oberfläche erstrekkende Kleberschicht (15) aufweist, welche an den Durchbrechungen (11) des Modulträgers (2) Aussparungen (18) für den Durchtritt der Kontaktbrükke(n) (10)aufweist.

8. Chipmodul nach einem der Ansprüche 1 bis 7, **dadurch gekennzeichnet, daß** die Verbindungsstellen der minsdestens einen Kontaktbrücke (10) mit der Kontaktfläche (3) von einer Vergußmasse umgeben sind.

9. Chipkarte mit mindestens einem Chipmodul (1) mit mindestens einer elektrischen Kontaktfläche (3), die mit einem Bauelement (21) im Chipkartenkörper (20) verbunden ist, **gekennzeichnet durch** ein Chipmodul (1) nach einem der Ansprüche 1 bis 8, wobei mindestens eine Kontaktbrücke (10) die elektrische Kontaktfläche (3) mit dem Bauelement (21) im Chipkartenkörper (20) verbindet.

10. Chipkarte nach Anspruch 9, **dadurch gekennzeichnet, daß** die Chipkarte eine Dual-Interface-Karte und das Bauelement (21) im Chipkartenkörper (20) ein Interfacebauelement (21) zur kontaktlosen Datenübertragung ist.

11. Verfahren zur Herstellung eines Chipmoduls (1), bei dem ein Modulträger (2) auf einer Seite mit mindestens einer elektrischen Kontaktfläche (3), auf der gegenüberliegenden Seite mit mindestens einem elektrischen Bauteil (4) und mit Durchbrechungen (5) für die Kontaktierung (6) der Kontaktfläche (3) und des Bauteils (4) versehen wird, **dadurch gekennzeichnet, daß** auf der das Bauteil (4) aufweisenden Seite des Modulträgers (2) mindestens eine Kontaktbrücke (10) angeordnet wird, welche an ihren beiden Enden (12, 13) durch im Modulträger (2) eingebrachte Durchbrechungen (11) hindurch mit der Kontaktfläche (3) verbunden wird.

12. Verfahren nach Anspruch 11, **dadurch gekennzeichnet, daß** die Kontaktbrücke (10) aus Draht gebondet wird.

13. Verfahren nach Anspruch 11 oder 12, **dadurch gekennzeichnet, daß** eines der Enden (12,13) der Kontaktbrücke (10) durch eine Durchbrechung (5) für die Kontaktierung (6) der Kontaktfläche (3) mit dem Bauteil (4) durchgeführt wird.

14. Verfahren nach einem der Ansprüche 11 bis 13, **dadurch gekennzeichnet, daß** mindestens zwei Kontaktbrücken (10) parallel zueinander mit der jeweiligen Kontaktfläche (3) verbunden werden.

15. Verfahren nach einem der Ansprüche 11 bis 14, **dadurch gekennzeichnet, daß** die beiden Enden (12,13) der mindestens einen Kontaktbrücke (10) mittels unterschiedlicher Bondingmethoden mit der Kontaktfläche (3) verbunden werden.

16. Verfahren nach Anspruch 14 oder 15, **dadurch gekennzeichnet, daß** die jeweils zueinander benachbart angeordneten Enden (12,13) paralleler Kontaktbrücken (10) mittels unterschiedlicher Bondinginethoden mit der Kontaktfläche (3) verbunden werden.

17. Verfahren nach einem der Ansprüche 11 bis 16, **dadurch gekennzeichnet, daß** auf den Modulträger (2) auf der bauteilseitigen Oberfläche vor dem Herstellen der Kontaktbrücke(n) (10) eine Kleberschicht (15) aufgebracht wird, welche an den Durchbrechungen (11) des Modulträgers (2) Aussparungen (18) für den Durchtritt der Kontaktbrücke(n) (10) aufweist.

18. Verfahren nach Anspruch 17, **dadurch gekennzeichnet, daß** die Kleberschicht (15) eine Aussparung (16) für das Bauteil (4) aufweist und das Bauteil (4) nach dem Aufbringen der Kleberschicht (15) mit einer Vergußmasse (7) vergossen wird.

19. Verfahren nach einem der Ansprüche 11 bis 18, **dadurch gekennzeichnet, daß** die Verbindungsstellen der mindestens einen Kontaktbrücke (10) mit der Kontaktfläche (3) mit einer Vergußmasse vergossen werden.

20. Verfahren zur Herstellung einer Chipkarte,
bei dem in einen Chipkartenkörper (20) ein Chipmodul (1) eingebracht wird, und dabei mindestens eine Kontaktfläche (3) des Chipmoduls (1) mit mindestens einem Bauelement (21) in dem Chipkartenkörper (20) elektrisch verbunden wird, **dadurch gekennzeichnet, daß** in den Chipkartenkörper (20) ein nach einem Verfahren gemäß einem der Ansprüche 11 bis 19 hergestelltes Chipmodul (1) eingebracht wird, und dabei die Verbindung zwischen der Kontaktfläche (3) des Chipmoduls (1) mit dem Bauelement (21) im Chipkartenkörper (20) mittels der mindestens einen Kontaktbrücke (10) des Chipmoduls (1) erfolgt.

21. Verfahren nach Anspruch 20, **dadurch gekennzeichnet, daß** das Chipmodul (1) mit einer Kleberschicht (15) in eine Aussparung (23) des Chipkartenkörpers (20) eingeklebt wird.

22. Verfahren nach Anspruch 20 oder 21, **dadurch gekennzeichnet, daß** die Chipkarte eine Dual-Interface-Karte ist und in den Chipkartenkörper (20) ein Interfacebauelement (21) zur kontaktlosen Datenübertragung eingebracht wird.

## Claims

1. A chip module (1) with a module carrier (2) having at least one electric contact surface (3) on one side of the module carrier (2) and at least one electric component (4) on the opposite side of the module carrier (2) and having openings (5) for the contacting (6) of the contact surface (3) and the component (4), **characterized in that** on the side of the module carrier (2) having the component (4) there is at least one contact bridge (10) connected at both ends (12, 13) with the contact surface (3) through openings (11) in the module carrier (2).

2. A chip module according to claim 1, **characterized in that** the contact bridge (10) consists of bonding wire.

3. A chip module according to claim 1 or 2, **characterized in that** one of the ends (12, 13) of the contact bridge (10) is fed through an opening (5) for the contacting (6) of the contact surface (3) with the component (4).

4. A chip module according to any of claims 1 to 3, **characterized by** at least two contact bridges (10) connected with the contact surface (3) in parallel with each other.

5. A chip module according to any of claims 1 to 4, **characterized in that** the two ends (12, 13) of the at least one contact bridge (10) are connected with the contact surface (3) by different bonding methods.

6. A chip module according to claim 4 or 5, **characterized in that** the adjacent ends (12, 13) of parallel contact bridges (10) are connected with the contact surface (3) by different bonding methods.

7. A chip module according to any of claims 1 to 6, **characterized in that** the module carrier (2) has an adhesive layer (15) extending between the module carrier (2) and the contact bridge or bridges (10) on the component-side surface, said layer having gaps (18) for passage of the contact bridge or bridges (10) at the openings (11) of the module carrier (2).

8. A chip module according to any of claims 1 to 7, **characterized in that** the connecting points of the at least one contact bridge (10) with the contact surface (3) are surrounded by a casting compound.

9. A chip card with at least one chip module (1) having at least one electric contact surface (3) connected with a component (21) in the chip card body (20), **characterized by** a chip module (1) according to any of claims 1 to 8, whereby at least one contact bridge (10) connects the electric contact surface (3) with the component (21) in the chip card body (20).

10. A chip card according to claim 9, **characterized in that** the chip card is a dual interface card and the component (21) in the chip card body (20) is an interface component (21) for contactless data transfer.

11. A method for producing a chip module (1) wherein a module carrier (2) is provided on one side with at least one electric contact surface (3), on the opposite side with at least one electric component (4) and with openings (5) for the contacting (6) of the contact surface (3) and the component (4), **characterized in that** on the side of the module carrier (2) having the component (4) there is at least one contact bridge (10) that is connected at both ends (12, 13) with the contact surface (3) through openings (11) formed in the module carrier (2).

12. A method according to claim 11, **characterized in that** the contact bridge (10) is bonded of wire.

13. A method according to claim 11 or 12, **characterized in that** one of the ends (12, 13) of the contact bridge (10) is fed through an opening (5) for the contacting (6) of the contact surface (3) with the component (4).

14. A method according to any of claims 11 to 13, **characterized in that** at least two contact bridges (10) are connected with the particular contact surface (3) in parallel with each other.

15. A method according to any of claims 11 to 14, **characterized in that** the two ends (12, 13) of the at least one contact bridge (10) are connected with the contact surface (3) by different bonding methods.

16. A method according to claim 14 or 15, **characterized in that** the adjacent ends (12, 13) of parallel contact bridges (10) are connected with the contact surface (3) by different bonding methods.

17. A method according to any of claims 11 to 16, **characterized in that** an adhesive layer (15) is applied to the module carrier (2) on the component-side surface before production of the contact bridge or bridges (10), said layer having gaps (18) for passage of the contact bridge or bridges (10) at the openings (11) of the module carrier (2).

18. A method according to claim 17, **characterized in that** the adhesive layer (15) has a gap (16) for the component (4) and the component (4) is cast with a casting compound (7) after application of the adhesive layer (15).

19. A method according to any of claims 11 to 18, **characterized in that** the connecting points of the at least one contact bridge (10) with the contact surface (3) are cast with a casting compound.

20. A method for producing a chip card, wherein a chip module (1) is incorporated in a chip card body (20) and at the same time at least one contact surface (3) of the chip module (1) is electrically connected with at least one component (21) in the chip card body (20), **characterized in that** a chip module (1) produced by a method according to any of claims 11 to 19 is incorporated in the chip card body (20) and at the same time the connection between the contact surface (3) of the chip module (1) with the component (21) in the chip card body (20) is effected by means of the at least one contact bridge (10) of the chip module (1).

21. A method according to claim 20, **characterized in that** the chip module (1) is glued into a recess (23) of the chip card body (20) with an adhesive layer (15).

22. A method according to claim 20 or 21, **characterized in that** the chip card is a dual interface card and an interface component (21) for contactless data transfer is incorporated in the chip card body (20).

## Revendications

1. Module puce (1) avec un support de module (2) doté d'au moins une surface de contact électrique (3) sur un côté du support de module (2) et d'au moins un composant électrique (4) sur le côté opposé du support de module (2), et doté de passages (5) pour établir les contacts (6) de la surface de contact (3) et du composant (4), **caractérisé en ce qu'**au moins un pont de contact (10) est disposé sur le côté du support de module (2) présentant le composant (4), lequel pont est raccordé à la surface de contact (3) à ses deux extrémités (12, 13) par des passages (11) dans le support de module (2).

2. Module puce selon la revendication 1, **caractérisé en ce que** le pont de contact (10) est en fil conducteur.

3. Module puce selon la revendication 1 ou 2, **caractérisé en ce que** l'une des extrémités (12, 13) du pont de contact (10) est réalisée avec un passage (5) pour établir les contacts (6) de la surface de contact (3) avec le composant (4).

4. Module puce selon l'une quelconque des revendications 1 à 3, **caractérisé par** au moins deux ponts de contact (10) parallèles raccordés avec la surface de contact (3).

5. Module puce selon l'une quelconque des revendications 1 à 4, **caractérisé en ce que** les deux extrémités (12, 13) d'au moins un pont de contact (10) sont raccordées à la surface de contact (3) au moyen de différentes méthodes de connexion.

6. Module puce selon la revendication 4 ou 5, **caractérisé en ce que** les extrémités (12, 13) des ponts de contact (10) parallèles, adjacentes l'une à l'autre, sont raccordées à la surface de contact (3) au moyen de différentes méthodes de connexion.

7. Module puce selon l'une quelconque des revendications 1 à 6, **caractérisé en ce que** le support de module (2) présente une couche adhésive (15) s'étendant entre le support de module (2) et le/les pont(s) de contact (10) sur la surface du côté du composant, laquelle couche présente des évidements (18) pour le passage du/des pont(s) de contact (10) aux passages (11) du support de module (2).

8. Module puce selon l'une quelconque des revendications 1 à 7, **caractérisé en ce que** les points de raccordement d'au moins un pont de contact (10) avec la surface de contact (3) sont entourés d'une masse de scellement.

9. Carte à puce dotée d'au moins un module puce (1) avec au moins une surface de contact électrique (3) raccordée à un composant (21) dans le corps de la carte à puce (20), **caractérisée par** un module puce (1) selon l'une quelconque des revendications 1 à 8, dans lequel au moins un pont de contact (10) raccorde la surface de contact électrique (3) au composant (21) dans le corps de la carte à puce.

10. Carte à puce selon la revendication 9, **caractérisée en ce que** la carte à puce est une carte à double interface et le composant (21) dans le corps de la carte à puce (20) est un composant d'interface (21) pour la transmission de données sans contact.

11. Procédé de fabrication d'un module puce (1), dans lequel un support de module (2) est muni sur un côté d'au moins une surface de contact électrique (3), d'au moins un composant électrique (4) sur le côté opposé, et de passages (5) pour établir les contacts (6) de la surface de contact (3) et du composant (4), **caractérisé en ce qu'**au moins un pont de contact (10) est disposé sur le côté du support de module (2) présentant le composant (4), lequel pont est raccordé à la surface de contact (3) à ses deux extrémités (12, 13) par des passages (11) pratiqués dans le support de module (2).

12. Procédé selon la revendication 11, **caractérisé en ce que** le pont de contact (10) est connecté par fil métallique.

13. Procédé selon la revendication 11 ou 12, **caractérisé en ce que** l'une des extrémités (12, 13) du pont de contact (10) est réalisée avec un passage (5) pour établir les contacts (6) de la surface de contact (3) avec le composant (4).

14. Procédé selon l'une quelconque des revendications 11 à 13, **caractérisé en ce qu'**au moins deux ponts de contact (10) parallèles l'un par rapport à l'autre sont raccordés à la surface de contact (3).

15. Procédé selon l'une quelconque des revendications 11 à 14, **caractérisé en ce que** les deux extrémités (12, 13) d'au moins un pont de contact (10) sont raccordées à la surface de contact (3) au moyen de différentes méthodes de connexion.

16. Procédé selon la revendication 14 ou 15, **caractérisé en ce que** les extrémités (12, 13) des ponts de contact (10) parallèles, adjacentes l'une à l'autre, sont raccordées à la surface de contact (3) au moyen de différentes méthodes de connexion.

17. Procédé selon l'une quelconque des revendications 11 à 16, **caractérisé en ce qu'**une couche adhésive (15) est appliquée sur le support de module (2), sur la surface du côté du composant avant la fabrication du/des pont(s) de contact (10), laquelle couche présente des évidements (18) pour le passage du/des pont(s) de contact (10) aux passages (11) du support de module (2).

18. Procédé selon la revendication 17, **caractérisé en ce que** la couche adhésive (15) présente un évidement (16) pour le composant (4) et le composant (4) est scellé avec une masse de scellement (7) après l'application de la couche adhésive (15).

19. Procédé selon l'une quelconque des revendications 11 à 18, **caractérisé en ce que** les points de raccordement du au moins un pont de contact (10) sont scellés avec une masse de scellement.

20. Procédé de fabrication d'une carte à puce, dans lequel un module puce (1) est appliqué dans un corps de carte à puce (20), et qu'à cet effet au moins une surface de contact électrique (3) du module puce (1) est raccordée électriquement à au moins un composant (21) dans le corps de la carte à puce (20), **caractérisé en ce qu'**un module puce (1) fabriqué d'après un procédé selon l'une quelconque des revendications 11 à 19 est inséré dans le corps de la carte à puce (20), et qu'à cet effet le raccordement entre la surface de contact (3) du module puce (1) et le composant (21) dans le corps de la carte à puce (20) est réalisé par le biais du au moins un pont de contact (10) du module puce (1).

21. Procédé selon la revendication 20, **caractérisé en ce que** le module puce (1) est collé par une couche adhésive (15) dans un évidement (23) du corps de la carte à puce (20).

22. Procédé selon la revendication 20 ou 21, **caractérisé en ce que** la carte à puce est une carte à double interface et un composant d'interface (21) est appliqué dans le corps de la carte à puce (20) pour la transmission de données sans contact.
